# EUROPEAN PATENT APPLICATION

(11) **EP 4 822 918 A1**
(43) Date of publication of application: **14.10.2026**
(21) Application number: 25189129.7
(22) Date of filing: 11.07.2025
(51) Int. Cl.: H01S 5/183

(54) **VERTICAL-CAVITY SURFACE-EMITTING LASER DEVICE**

(30) Priority: 11.04.2025 US 202519176799
(71) Applicant: II-VI Delaware, Inc., Wilmington, DE 19890 (US)
(72) Inventor: KAISER, Wolfgang, Wilmington, 19890 (US); ZEGHUZI,, Anissa, Wilmington, 19890 (US); HOSER, Mirko, Wilmington, 19890 (US); HÖNL, Simon, Wilmington, 19890 (US)
(74) Representative: Schmidt, Christian

(57) **Abstract**

Embodiments of the present disclosure include a vertical-cavity surface-emitting laser device, the device including a mesa with a non-circular cross-section. Embodiments also include a plurality of layers with one or more oxide layers. Embodiments may also include one or more non-oxide layers. The mesa may be operable as a dielectric top mirror.

## Description

### TECHNICAL FIELD

The present disclosure generally relates to a vertical-cavity surface-emitting laser device.

### BACKGROUND

Aspects of the present disclosure relate to a vertical-cavity surface-emitting laser device. Various issues may exist with conventional solutions for vertical-cavity surface-emitting laser devices. In this regard, conventional vertical-cavity surface-emitting laser devices may be costly, cumbersome, and/or inefficient.

Limitations and disadvantages of conventional systems and methods will become apparent to one of skill in the art, through comparison of such approaches with some aspects of the present methods and systems set forth in the remainder of this disclosure with reference to the drawings.

### BRIEF SUMMARY OF THE DISCLOSURE

Shown in and/or described in connection with at least one of the figures, and set forth more completely in the claims is a vertical-cavity surface-emitting laser device.

These and other advantages, aspects and novel features of the present disclosure, as well as details of illustrated embodiments thereof, will be more fully understood from the following description and drawings.

### BRIEF DESCRIPTION OF THE DRAWINGS

The various features and advantages of the present disclosure may be more readily understood with reference to the following detailed description taken in conjunction with the accompanying drawings, wherein like reference numerals designate like structural elements.
FIG. 1A is a block diagram illustrating a vertical-cavity surface-emitting laser device, according to some embodiments of the present disclosure.
FIG. 1B is an exemplary embodiment of the present disclosure that describes a vertical-cavity surface-emitting laser device 100.
FIG. 2A is a block diagram further illustrating the vertical-cavity surface-emitting laser device from FIG. 1A, according to some embodiments of the present disclosure.
FIG. 2B shows an exemplary disclosure of a laser device 100 with an elliptical cross section 112, according to some embodiment of the present disclosure.
FIG. 2C shows an exemplary disclosure of a laser device 100 with a concentric elliptic ring shape cross section 112 / 213, according to some embodiment of the present disclosure.
FIG. 2D and FIG. 2E show exemplary non-circular cross-sections 112, in accordance with various embodiments of the disclosure.
FIG. 3A is a block diagram further illustrating the vertical-cavity surface-emitting laser device from FIG. 1A, according to some embodiments of the present disclosure.
FIG. 3B is an exemplary embodiment according to the disclosure comprising a plurality of mirror pairs.
FIG. 3C is an exemplary embodiment according to the disclosure comprising a plurality of mirror pairs.

### DESCRIPTION

The following discussion provides various examples of a vertical-cavity surface-emitting laser device. Such examples are non-limiting, and the scope of the appended claims should not be limited to the particular examples disclosed. In the following discussion, the terms "example" and "e.g." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The terms "comprises," "comprising," "includes," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Embodiments of the present disclosure may comprise a vertical-cavity surface-emitting laser device (VCSEL), the device comprising a mesa, comprising a non-circular cross-section. Embodiments may also comprise a plurality of layers, comprising one or more oxide layers. Embodiments may also comprise one or more non-oxide layers. In some embodiments, the mesa may be operable as a dielectric top mirror.

In some embodiments, the oxide layers may comprise aluminum oxide (AlOx). In some embodiments, the non-oxide layers may comprise one or more of Aluminum Gallium Arsenide (AlGaAs), Gallium Arsenide (GaAs), Aluminum Indium Phosphide (AllnP), Gallium Indium Phosphide (GalnP), Aluminum Gallium Arsenide Phosphide (AlGaAsP), Aluminum Indium Arsenide Phosphide (AllnAsP), and/or Gallium Indium Arsenide Phosphide (GalnAsP). In some embodiments, the one or more oxide layers and the non-oxide layers may be arranged in a stack of oxide layers alternating with one or more non-oxide layers.

In some embodiments, the non-circular cross-section of the mesa may be an elliptic cross-section. In some embodiments, the non-circular cross-section may comprise an elliptic plane shape or one or more concentric elliptic ring shape planes, or a plane shaped by a plurality of abutting circular planes. In some embodiments, the mesa may comprise a passivation layer covering the plurality of layers.

In some embodiments, the passivation layer may comprise AlOx. In some embodiments, the mesa may comprise a stack of alternating AlGaAs or GaAs or AllnP or GaInP or AlGaAsP or AlInAsP or GalnAsP layers. In some embodiments, adjacent layers may comprise different aluminum content.

Embodiments may also comprise alternating layers forming mirror pairs. In some embodiments, the mesa has a diameter of less than 6 micrometers. In some embodiments, the non-circular cross-section may be operable to select one or more optical modes for emission. In some embodiments, the non-circular cross-section may be operable for polarization mode splitting. Embodiments may also comprise a top surface of the mesa that may be planar, hemispherical or dome-shaped or curvature shaped. In some embodiments, the device according to the disclosure may comprise one or more of a substrate, a bottom mirror, and active region, a contact, and a current confining structure, e.g., an oxide aperture.

Conventional VCSELs may have insufficient bandwidth to achieve very high bandwidths, for example for 200 Gbs operation. It may be desirable to provide smaller VCSELs with reduced capacity and higher parasitic bandwidth to obtain faster operation. This disclosure illustrates a novel monolithic high index contrast distributed Bragg reflector (DBR) for high-speed VCSEL.

In conventional VCSELs, current may be injected through top and bottom mirrors that may be formed by DBRs comprising semiconductor materials, for example aluminum gallium arsenide. In those DBRs, the index contrast between a high and low index material may be small. This may necessitate a high number of mirror pairs to get desirable high reflectivity. This may have drawbacks, for example higher mode volume, as well as resistive and absorbing mirrors.

This disclosure improves on conventional VCSELs and uses oxidized layer stacks to form mirrors as top DBRs. The index difference achieved may be higher, requiring fewer mirror pairs. A desirable effect of this may be reduced mode volume and increased modulation bandwidth. Furthermore, the mirror may be non-absorbing and intra-cavity contacts may be placed below the mirror to reduce resistance. The approach of this disclosure may be monolithic and may be combined with other design options such as transverse gratings and mode filters.

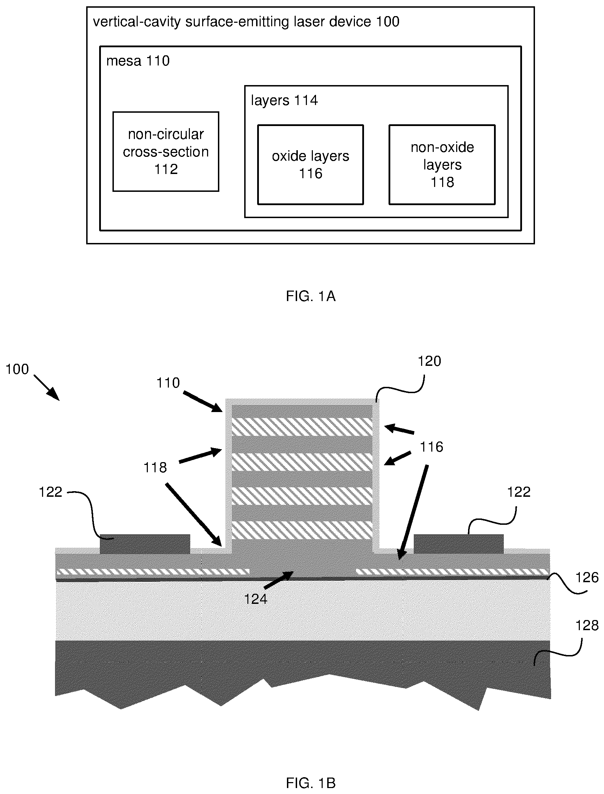

Referring now to FIG. 1A, FIG. 1A is a block diagram that describes a vertical-cavity surface-emitting laser device 100, according to some embodiments of the present disclosure. In some embodiments, the vertical-cavity surface-emitting laser device 100 may comprise a mesa 110. The mesa 110 may comprise a non-circular cross-section 112 and a plurality of layers 114. The plurality of layers 114 may comprise one or more oxide layers 116 and one or more non-oxide layers 118. The mesa 110 may be operable as a dielectric top mirror. In some embodiments, the one or more non-oxide layers 118 may comprise AlOx.

In some embodiments, one or more of AlGaAs, GaAs, AllnP, GaInP, AlGaAsP, AllnAsP, and/or GaInAsP may be used for non-oxide layers 118. In some embodiments, the one or more oxide layers 116 and the non-oxide layers 118 may be arranged in one or more stacks of oxide layers alternating with one or more non-oxide layers. In some embodiments, the non-circular cross-section 112 may be an elliptic cross-section. In some embodiments, the mesa 110 may comprise a diameter of less than 6 micrometers.

In some embodiments, the non-circular cross-section 112 may be operable to select one or more optical modes for emission. In some embodiments, the non-circular cross-section 112 may be operable for polarization mode splitting. In some embodiments, a top surface of the mesa 110 may be planar, hemispherical or dome-shaped or curvature shaped. In some embodiments, one or more of a substrate, a bottom mirror, and active region, a contact, and a current confining structure, for example an oxide aperture, may be comprised, as will be illustrated in FIG. 1B, for example.

FIG. 1B is an exemplary embodiment of the present disclosure that describes a vertical-cavity surface-emitting laser device 100. There is shown, the vertical-cavity surface-emitting laser device 100 that may comprise a mesa 110. The mesa 110 may comprise a non-circular cross-section 112 (not shown) and a plurality of layers 114, comprising one or more oxide layers 116 and one or more non-oxide layers 118. The mesa 110 may be operable as a dielectric top mirror. There is further shown a passivation layer 120, covering layers 116, 118. The passivation layer may be a protective layer. In some embodiments, the passivation layer 120 may comprise AlOx. There are also shown contacts 122, an oxide aperture 124, an active region 126, a bottom mirror 127, and a substrate 128.

In some embodiments, the one or more oxide layers 116 may comprise AlOx. In some embodiments, one or more of AlGaAs, GaAs, AllnP, GaInP, AlGaAsP, AlInAsP, and/or GaInAsP may be used for non-oxide layers 118. In some embodiments, the one or more oxide layers 116 and the non-oxide layers 118 may be arranged in a stack of oxide layers alternating with one or more non-oxide layers. In some embodiments, the mesa 110 may comprise a diameter of less than 6 micrometers.

After initial epitaxy of the vertical-cavity surface-emitting laser device 100, for example using layers of AlGaAs with low aluminum content and layers of AlGaAs with high aluminum content, oxidation may generate AlOx dominated layers 116 from the high aluminum content layers. Often, the dielectric top mirror and the oxide aperture may be formed at the same process step. A top DBR may be formed, for example, by fully oxidizing (ca. 98%) AlGaAs to generate a AlOx / AlGaAs mirrors. Epitaxial growth may define the thickness of the layers accurately. Suitable mirrors with little absorption may lead to lower optical losses, lower threshold current and higher differential gains.

For example, etching may be used to form a mesa 110. In some embodiments, the non-circular cross-section 112 may be operable to select one or more optical modes for emission. In some embodiments, the non-circular cross-section 112 may be operable for polarization mode splitting. In some embodiments, a top surface of the mesa 110 may be planar, hemispherical or dome-shaped or curvature shaped.

Strong mode volume reduction may increase the bandwidth of the VCSEL 100. Small AlOx / AlGaAs DBRs may advantageously be of a small diameter, for example a few micrometers, for example less than 8 or 6 micrometers, to generate devices with low capacitance.

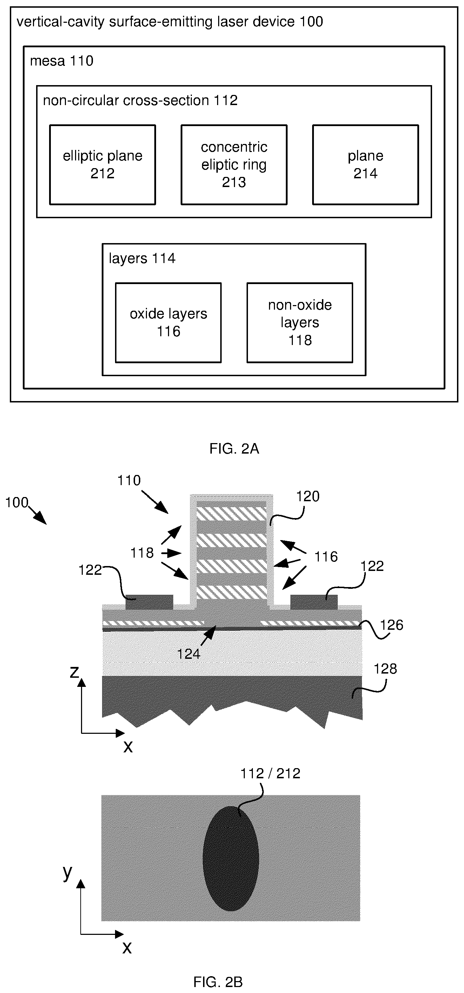

FIG. 2A is a block diagram that further describes the vertical-cavity surface-emitting laser device 100 from FIG. 1A, according to some embodiments of the present disclosure. In some embodiments, the non-circular cross-section 112 may be an elliptic cross-section. In some embodiments, the non-circular cross-section 112 may comprise an elliptic plane shape 212, one or more concentric elliptic ring shape planes 213, and a plane 214 shaped by a plurality of abutting circular planes.

FIG. 2B shows an exemplary disclosure of a laser device 100 with an elliptical cross section 112. There is shown an elliptical plane shape 212.

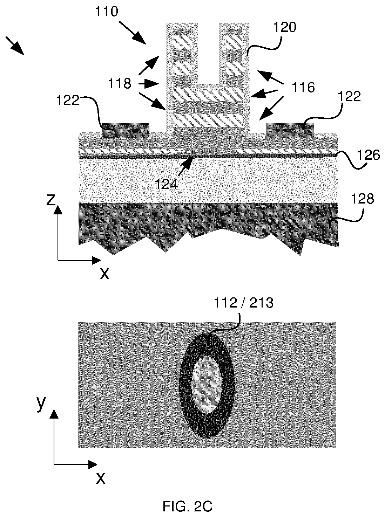

FIG. 2C shows an exemplary disclosure of a laser device 100 with a concentric elliptic ring shape cross section 112 / 213.

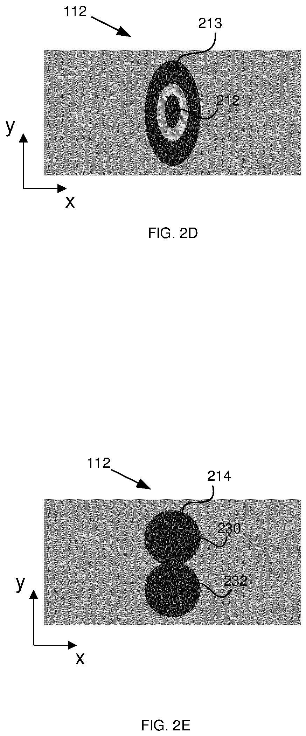

FIG. 2D and FIG. 2E show exemplary non-circular cross-sections 112, in accordance with various embodiments of the disclosure. In some embodiments, the non-circular cross-section 112 may comprise one or more concentric elliptic ring shape planes 213. In accordance with various embodiments of the disclosure, FIG. 2D may illustrate the combination of an elliptical plane shape 212 and an elliptical ring shape 213. FIG. 2E may illustrate an exemplary non-circular cross-section 212 comprising a plane 214 shaped by a plurality of abutting circular planes (230, 232).

FIG. 2B through FIG. 2E illustrate some embodiments of VCSEL 100 wherein the non-circular cross-section 112 may be operable to select one or more optical modes for emission. In some embodiments, the non-circular cross-section 112 may be operable for polarization mode splitting. In accordance with various embodiments of the disclosure, suitable selection of the non-circular cross-section 112 may be advantageous for mode selection and splitting.

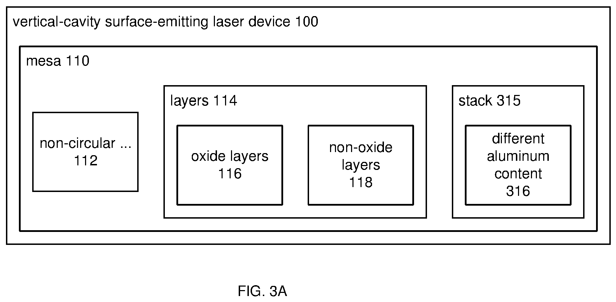

FIG. 3A is a block diagram that further describes the vertical-cavity surface-emitting laser device 100 from FIG. 1A, according to some embodiments of the present disclosure. In some embodiments, the mesa 110 may comprise a stack 315 of alternating AlGaAs or GaAs or AllnP or GaInP or AlGaAsP or AllnAsP or GalnAsP layers. The stack 315 may comprise different aluminum content 316 in adjacent layers. In some embodiments, each pair of alternating layers may form a mirror pair.

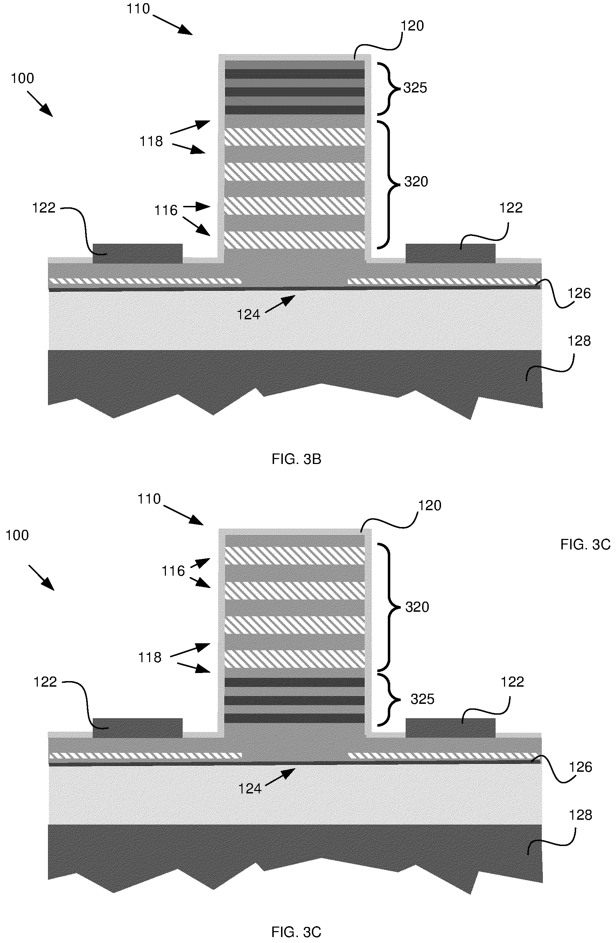

FIG. 3B is an exemplary embodiment according to the disclosure comprising a plurality of mirror pairs. There is shown a hybrid mirror implementation, comprising, for example, AlOx/GaAs mirror pairs 320 and AlGaAs mirror pairs 325. It will be understood that the specific materials used for the mirror pairs are exemplary.

FIG. 3C is an exemplary embodiment according to the disclosure comprising a plurality of mirror pairs. FIG. 3C is similar to FIG. 3 B, but the exemplary AlOx/GaAs mirror pairs 320 and the AlGaAs mirror pairs 325 are stacked in a different order. It will be understood that the specific materials used for the mirror pairs are exemplary.

The present disclosure comprises reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will comprise all examples falling within the scope of the appended claims.

## Claims

1. A vertical-cavity surface-emitting laser device, said device comprising:
a mesa, comprising:
a non-circular cross-section; and
a plurality of layers, comprising:
one or more oxide layers; and
one or more non-oxide layers;
wherein said mesa is operable as a dielectric top mirror and to provide mode selection.

2. The device according to claim 1, wherein said oxide layers comprise AlOx.

3. The device according to claim 1, wherein said non-oxide layers comprise one or more of AlGaAs, GaAs, AllnP, GalnP, AsGaAsP, AllnAsP, and/or GalnAsP.

4. The device according to claim 1, wherein said one or more oxide layers and said non-oxide layers are arranged in a stack of oxide layers alternating with one or more non-oxide layers.

5. The device according to claim 1, wherein said non-circular cross-section is an elliptic cross-section.

6. The device according to claim 1, wherein said non-circular cross-section comprises an elliptic plane shape and/or one or more concentric elliptic ring shape planes, and/or a plane shaped by a plurality of abutting circular planes.

7. The device according to claim 1, wherein said mesa is covered by a passivation layer.

8. The device according to claim 7, wherein said passivation layer comprises AlOx.

9. The device according to claim 1, wherein said mesa comprises a stack of alternating AlGaAs or GaAs or AlInP or GaInP or AsGaAsP or AlInAsP or GalnAsP layers, and wherein adjacent layers comprise different aluminum content.

10. The device according to claim 9, wherein each pair of said alternating layers form a mirror pair,

11. The device according to claim 1, wherein said mesa has a diameter of less than 6 micrometers.

12. The device according to claim 1, wherein said non-circular cross-section is operable to select one or more optical modes for emission.

13. The device according to claim 1, wherein said non-circular cross-section is operable for polarization mode splitting.

14. The device according to claim 1, wherein a top surface of said mesa is planar, hemispherical or dome-shaped or curvature shaped.

15. The device according to claim 1, further comprising one or more of a substrate, a bottom mirror, and active region, a contact, and current confining structure.
